# EUROPÄISCHE PATENTSCHRIFT

(11) **EP 1 443 652 B1**
(45) Veröffentlichungstag und Bekanntmachung des Hinweises auf die Patenterteilung: **01.10.2008**
(21) Anmeldenummer: 04000558.9
(22) Anmeldetag: 13.01.2004
(51) Int. Cl.: H03L 7/089, H03L 7/197

(54) **Schaltungsanordnung mit Phasendetektor und Phasenregelschleife mit der Schaltungsanordnung**
Circuit arrangement with phase detector and phase-locked loop including the same
Circuit avec détecteur de phase et boucle d'asservissement de phase avec un tel circuit

(30) Priorität: 31.01.2003 DE 10303939
(43) Veröffentlichungstag der Anmeldung: 04.08.2004
(73) Patentinhaber: Infineon Technologies AG, 81669 München (DE)
(72) Erfinder: Märzinger, Günter, 4161 Ulrichsberg (AT)
(74) Vertreter: Epping - Hermann - Fischer

(56) Entgegenhaltungen:
- EP-A- 0 458 269
- DE-A1- 4 342 344
- US-A- 6 002 273

## Beschreibung

Die vorliegende Erfindung betrifft eine Schaltungsanordnung mit Phasendetektor sowie eine Phasenregelschleife mit der Schaltungsanordnung.

Phasendetektoren sind normalerweise dazu geeignet, die Phasenlage zweier an Eingängen des Phasendetektors anliegender Signale miteinander zu vergleichen, eine eventuell vorhandene Phasenabweichung zwischen beiden Eingangssignalen zu ermitteln und an ihrem Ausgang ein Signal abzugeben, welches entweder proportional oder zumindest abhängig ist von der Phasendifferenz der Eingangssignale.

Phasendetektoren werden beispielsweise in Phasenregelkreisen eingesetzt, um ein zu erzeugendes Signal mit gewünschter Frequenz auf eine Bezugssignalquelle einzurasten. Mit Phasenregelkreisen können hochpräzise Signale mit hoher Frequenzkonstanz generiert werden, indem der Bezug auf eine Referenzquelle, beispielsweise einen Quarzoszillator, hergestellt wird. Dabei kann jedoch die erzeugte Frequenz unterschiedlich von der Bezugsfrequenz sein. Hierfür ist normalerweise im Rückkopplungszweig des Phasenregelkreises ein Frequenzteiler vorgesehen.

Um in digitalen Kommunikationsanwendungen bereits bei der Frequenzerzeugung in der Phasenregelschleife eine Trägermodulation zu erreichen, ist in Weiterbildungen der Phasenregelschleife ein sogenannter Fractional-n-Frequenzteiler im Rückkopplungspfad vom Oszillator auf den Phasendetektor vorgesehen, mit dem über ein Zeitintervall gemittelt Bruchzahlen-Teilerverhältnisse einstellbar sind. Derartige Phasenregelkreise können beispielsweise von einem digital codierten Modulationssignal über sogenannte ∑Δ-Wandler angesteuert werden. Das von einem Phasendetektor am Ausgang bereitgestellte, von der Phasendifferenz der Eingangssignale abhängige Signal wird normalerweise auf einen Ladungspumpenausgang gegeben, der einen Aufwärts- oder Abwärtsstrom erzeugt, welcher wiederum üblicherweise integriert wird und in eine entsprechende Steuerspannung umgesetzt einen steuerbaren Oszillator in der Weise steuert, daß die Phasendifferenz am Eingang des Detektors kleiner wird, bis sie verschwindet.

Solche Phasendetektoren, die nicht nur einen Phasenunterschied, sondern auch einen Frequenzunterschied bei dem Signalvergleich der Eingangssignale berücksichtigen können, werden als Phasen-Frequenz-Detektoren bezeichnet.

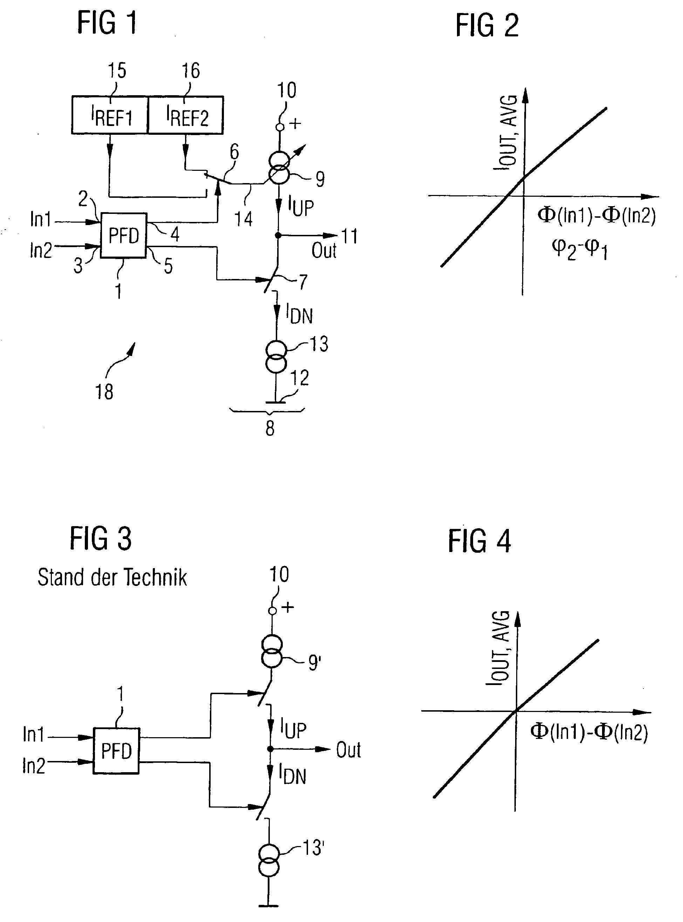

Eine herkömmliche Phasendetektoranordnung ist in Figur 3 gezeigt. Wenn in der Ladungspumpen-Ausgangsstufe 9', 13' eines Phasendetektors 1 die Aufwärts- und Abwärts-Stromquelle 9', 13' nicht einen ideal gleichen Strom liefern bei jeweiliger Aktivierung, so ergibt sich in nachteilhafter Weise ein Knick im Ursprung des Kennlinienfeldes der Ladungspumpen-Phasendetektor-Einheit, wobei in Figur 4 als Kennlinie der durchschnittliche Ausgangsstrom aufgetragen ist über der Phasenabweichung der Eingangssignale des Detektors. Da der Ursprung, in dem die Kennlinie abknickt, aber dem Arbeitspunkt des Phasendetektors entspricht, ergibt sich eine unerwünschte Nichtlinearität im Arbeitspunkt. Gerade bei den oben beschriebenen Fractional-n-Phasenregelkreisen, abgekürzt Fractional-n-PLLs, ist aber ein hochlinearer Zusammenhang zwischen Ausgangsstrom des Phasendetektors und Phasendifferenz der Eingangssignale von besonders großer Bedeutung für die zuverlässige Funktion der Schaltung.

In dem Dokument US 6,002,273 ist eine Möglichkeit angegeben, den beschriebenen Knick der Kennlinie des Ladungspumpen-Phasendetektor-Blocks aus dem Arbeitspunkt dieser Schaltungseinheit herauszuschieben. Hierfür ist dort zusätzlich zu den normalerweise vorhandenen beiden Stromquellen zur Erzeugung eines Aufwärts- und eines Abwärtsstroms eine dritte Stromquelle zur Linearisierung vorgesehen. Diese zusätzliche, dritte Stromquelle in der Ausgangsstufe des Phasendetektors, der sogenannten Ladungspumpe, bedeutet jedoch einen zusätzlichen Aufwand bei der Integration der Schaltung, insbesondere einen zusätzlichen Chipflächen- und Strombedarf. Dies ist jedoch insbesondere deshalb unerwünscht, da Phasenregelkreise oftmals in mobilen Geräten, beispielsweise Funk-Steckkarten, Mobiltelefonen oder Schnurlostelefonen eingesetzt werden, in denen es auf geringe Abmessungen, geringe Herstellkosten in Massenproduktion und geringen Strombedarf ankommt.

Das Dokument DE 4342344 A1 zeigt eine Schaltungsanordnung für eine Phasenregelschleife, die einen Phasendetektor, eine Referenzstromquelle und eine Ladungspumpe umfasst. Die Referenzstromquelle steuert eine Stromstärke eines ersten Stroms und eines zweiten Stroms der Ladungspumpe.

Das Dokument EP 0458269 A1 beschreibt einen Phasenregelkreis mit einer Ladungspumpe. Die Ladungspumpe umfasst einen ersten Transistor, der eine Versorgungsspannung einem Signalausgang zuleitet, und einen zweiten Transistor, der den Signalausgang mit einem Bezugspotentialanschluss verbindet.

Es ist Aufgabe der vorliegenden Erfindung, eine Schaltungsanordnung mit Phasendetektor sowie eine Phasenregelschleife mit der Schaltungsanordnung anzugeben, welche eine hochlineare Kennlinie zwischen Ausgangsstrom des Phasendetektors und Phasendifferenz der Eingangssignale bieten und zugleich mit geringerem Aufwand realisierbar sind.

Erfindungsgemäß wird die Aufgabe bezüglich der Schaltungsanordnung gelöst durch eine Schaltungsanordnung mit Phasendetektor laut Anspruch 1.

Gemäß dem vorgeschlagenen Prinzip ist eine der beiden Stromquellen der Ladungspumpen-Ausgangsstufe des Phasendetektors mit einer umschaltbaren Referenzstromzuführung ausgestattet. Somit wird mit Vorteil der Arbeitspunkt der Phasendetektor-Schaltung aus dem Ursprung der Kennlinie, die den Ausgangsstrom aufgetragen über den Phasenunterschied der Eingangssignale repräsentiert, herausgeschoben. Da die Schaltung gemäß vorliegendem Prinzip ohne eine dritte Stromquelle arbeiten kann, ist mit Vorteil eine Implementierung der Schaltung mit geringer Chipfläche und der Betrieb der Schaltung mit geringem Strombedarf möglich.

Zusammengefaßt wird mit dem vorgeschlagenem Prinzip der vorteilhafte Effekt der Arbeitspunktverschiebung lediglich durch Umschaltung des Referenzstroms von einer der beiden Stromquellen erreicht. Somit kann auf eine Offset-Stromquelle zum Zweck der Arbeitspunktverschiebung mit Vorteil verzichtet werden.

Gemäß einer bevorzugten Weiterbildung des vorgeschlagenen Prinzips sind die erste und die zweite Stromquelle in der Ausgangsstufe der Schaltungsanordnung mit Phasendetektor zur Bildung einer Serienschaltung miteinander verschaltet und die Serienschaltung ist zwischen einen Versorgungspotentialanschluß und einen Bezugspotentialanschluß der Schaltungsanordnung geschaltet. Dabei arbeitet bevorzugt die dem positiven Versorgungsanschluß zugewandte Stromquelle als sogenannte Aufwärts-Stromquelle, die einen positiven Strom aus dem Signalausgang der Schaltungsanordnung hinaus bei ihrer Aktivierung treibt, und die dem negativeren Versorgungsanschluß zugewandte Stromquelle arbeitet bevorzugt als Stromsenke, das heißt, daß ein negativer Stromfluß aus dem Signalausgang der Schaltung heraus stattfindet.

Der zweite Schalter, der der zweiten Stromquelle zugeordnet ist, ist bevorzugt entweder in einer Serienschaltung zwischen dem Signalausgang der Schaltung und einem der Stromquelle zugeordneten Versorgungs- oder Bezugspotentialanschluß vorgesehen. Alternativ ist der zweite Schalter zum Zu- und Abschalten der zweiten Stromquelle nicht in deren Lastkreis geschaltet, sondern ausgelegt zur Steuerung des der zweiten Stromquelle zugeordneten und diese ansteuernden Referenzstromkreises.

Um mit Stromquellen einer Ladungspumpenschaltung präzise Ströme bereitstellen zu können, werden diese normalerweise mit einem Bias- oder Bezugsstrom angesteuert. Durch Zu- und Wegschalten des Bezugsstroms kann bevorzugt die gesamte Stromquelle ein- und ausgeschaltet werden.

Bezüglich der Phasenregelschleife wird die Aufgabe gelöst durch eine Phasenregelschleife mit einer Schaltungsanordnung wie vorstehend beschrieben, aufweisend:
- einen gesteuerten Oszillator mit einem Steuereingang, der über ein Schleifenfilter an den Signalausgang der Schaltungsanordnung mit Phasendetektor angeschlossen ist, und mit einem Ausgang,
- einen Frequenzteiler, der den Ausgang des gesteuerten Oszillators mit dem ersten Eingang des Phasendetektors koppelt, und
- einen Bezugsfrequenz-Generator, der mit dem zweiten Eingang des Phasendetektors gekoppelt ist.

Die Vorteile der beschriebenen Phasendetektorschaltung mit Ladungspumpenausgangsstufe kommen besonders vorteilhaft bei Anwendung in einer PLL, Phase Locked Loop, zur Geltung, da hier ein linearer Zusammenhang zwischen Ausgangsstrom des Phasendetektors und Phasendifferenz der Eingangssignale, insbesondere im Arbeitspunkt der Anordnung, besonders wichtig ist.

Der Frequenzteiler ist bevorzugt als Fractional-n-Teiler ausgelegt, und die Phasenregelschleife ist somit zum Betrieb als ∑Δ-Modulator gemäß digitalen Modulationsverfahren geeignet.

Weitere Einzelheiten und vorteilhafte Ausgestaltungen der vorgeschlagenen Erfindung sind Gegenstand der Unteransprüche.

Die Erfindung wird nachfolgend an mehreren Ausführungsbeispielen anhand der Zeichnungen näher erläutert.

Es zeigen:
- Figur 1: ein erstes Ausführungsbeispiel einer Schaltungsanordnung mit Phasendetektor gemäß dem vorgeschlagenen Prinzip,
- Figur 2: die Kennlinie des Phasendetektors gemäß Figur 1,
- Figur 3: einen herkömmlichen Phasendetektor mit Ladungspumpenausgang gemäß Stand der Technik,
- Figur 4: die Kennlinie des Phasendetektors von Figur 3,
- Figur 5: ein zweites Ausführungsbeispiel einer Phasendetektorschaltung gemäß dem vorgeschlagenen Prinzip anhand eines Schaltplans und
- Figur 6: eine Phasenregelschleife mit Phasendetektorschaltung gemäß Figur 1 oder 5 anhand eines beispielhaften Blockschaltbilds.

Figur 1 zeigt eine Schaltungsanordnung mit Phasendetektor gemäß dem vorgeschlagenen Prinzip. Der Phasendetektor 1 ist als Phasen-Frequenz-Detektor ausgebildet und umfaßt einen Eingang 2 zum Zuführen eines Eingangssignals (IN1) mit einer ersten Phasenlage (Φ1) sowie einen weiteren Eingang 3 zum Zuführen eines Eingangssignals (IN2) mit einer zweiten Phasenlage (Φ2). Am Ausgang des Phasendetektors 1 sind zwei Ausgänge vorgesehen, wobei an einem ersten Ausgang 4 ein Aufwärts-Steuersignal und an einem zweiten Ausgang 5 ein Abwärts-Steuersignal in Abhängigkeit von einem Phasenunterschied (Φ2-Φ1) zwischen den Eingangssignalen (IN1, IN2) an den Eingängen (2, 3) des Detektors 1 bereitgestellt wird. Der Ausgang 4 des Phasendetektors ist an den Steuereingang eines ersten Schalters 6 angeschlossen, der Ausgang 5 des Phasendetektors ist an den Steuereingang eines zweiten Schalters 7 angeschlossen. Mit den Schaltern 6, 7 werden Stromquellenzweige einer Ladungspumpen-Ausgangsstufe 8 der Schaltungsanordnung mit Phasendetektor gemäß Figur 1 gesteuert. Eine erste Stromquelle 9, welche als Aufwärts-Stromquelle der Ladungspumpe 8 arbeitet, ist zwischen einen positiven Versorgungspotentialanschluß 10 und den Signalausgang 11 der Schaltungsanordnung angeschlossen. Zwischen den Signalausgang 11 und einen Bezugspotentialanschluß 12 der Schaltungsanordnung ist eine Serienschaltung umfassend den Schalter 7 und eine zweite Stromquelle 13, welche als Abwärts-Stromquelle der Ladungspumpe 8 ausgelegt ist und als Stromsenke arbeitet, geschaltet. Die erste Stromquelle 9 hat einen Referenzstromeingang 14, an dem ein zum Betrieb der Stromquelle erforderlicher Referenzstrom zugeführt wird. Der Ausgangsstrom der ersten Stromquelle 9, der mit Bezugszeichen I_{UP} versehen ist, ist dabei abhängig von dem am Eingang 14 eingespeisten Referenzstrom. Der Referenzstromeingang 14 ist an einen Lastanschluß des Schalters 6 gelegt und fest damit verbunden. Der Schalter 6 ist als Umschalter ausgelegt und mit einem weiteren Lastanschluß entweder an eine erste Referenzstromquelle 15 oder an eine zweite Referenzstromquelle 16 aufgeschaltet. Die Referenzstromquellen 15, 16 sind ausgelegt zum Bereitstellen fester, aber verschiedener Referenzströme I_{REF1}, I_{REF2}.

Da gemäß der Ansteuerung und Verschaltung des Schalters 6 mit dem Ruhestromeingang oder Referenzstromeingang der Stromquelle 9 und den beiden Stromquellen 15, 16 zur Bereitstellung von Referenzströmen die Stromquelle 9 nie ganz ausgeschaltet wird, sondern stets einen gewissen Strombetrag an den Signalausgang 11 abgibt, ist sichergestellt, daß die Kennlinie des Phasendetektors, nämlich des Ausgangsstroms I_{OUT} aufgetragen über dem Phasenunterschied Φ2-Φ1 am Eingang des Detektors 1 nicht durch den Ursprung, das heißt durch den Nullpunkt, verläuft. Damit wiederum befindet sich der Arbeitspunkt der Phasendetektoranordnung von Figur 1 nicht in einem eventuell vorhandenen Knick der Kennlinie, der dann vorkommt, wenn die Stromquellen 9, 13 keinen ideal gleichen Strombetrag liefern.

Gemäß der vorgeschlagenen Schaltung von Figur 1 ist lediglich eine Aufwärts-Stromquelle 9 und eine Abwärts-Stromquelle 13 in der Ausgangsstufe 8 der Ladungspumpenschaltung der Phasendetektoranordnung vorgesehen. Auf eine dritte, als KonstantStromquelle ausgelegte Stromquelle in der Ausgangsstufe kann verzichtet werden. Hierdurch ist der Flächenbedarf der Schaltung gering.

Die Schaltung gemäß Figur 3 mit zugehöriger Kennlinie gemäß Figur 4 wurde bereits eingangs erläutert und soll daher an dieser Stelle nicht noch einmal beschrieben werden.

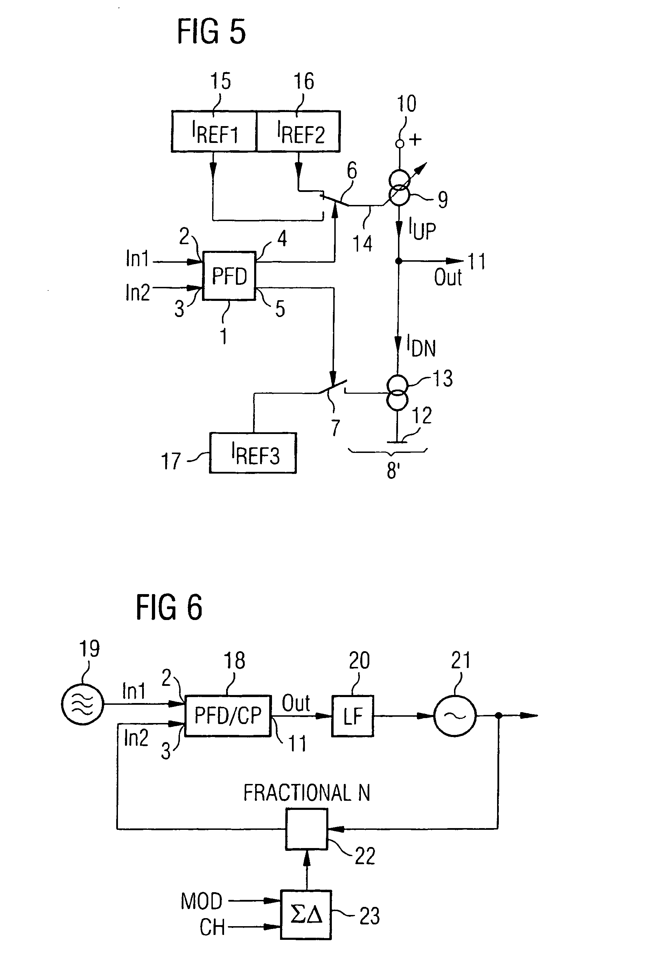

Figur 5 zeigt eine alternative Ausführungsform der Schaltungsanordnung mit Phasendetektor gemäß Figur 1. Gleiche Bezugszeichen bezeichnen gleiche oder gleich wirkende Schaltungsteile. Die Schaltung von Figur 5 entspricht in Aufbau und vorteilhafter Funktion weitgehend derjenigen von Figur 1 und unterscheidet sich lediglich dadurch, daß der Schalter 7 nicht im Laststromkreis in Serie zur zweiten Stromquelle 13 geschaltet ist, sondern vielmehr in die Referenzstromzuführung der zweiten Stromquelle 13 geschaltet ist. Der Schalter 7 verbindet lastseitig eine dritte Referenzstromquelle 17 mit einem Referenzstromeingang der zweiten Stromquelle 13. Der Steuereingang des zweiten Schalters 7 ist an den zweiten Ausgang 5 des Phasendetektors 1 gelegt. Lastseitig ist die zweite Stromquelle 13 nunmehr unmittelbar zwischen den Signalausgang 11 und den Bezugspotentialanschluß 12 geschaltet. Bezüglich der Ausgangsstufe 8' weist die Schaltung von Figur 5 eine höhere Symmetrie auf als die der Schaltung von Figur 1.

Figur 6 zeigt eine Fractional-N-PLL mit einer Schaltungsanordnung 18 mit Phasendetektor 1 gemäß Figur 1. Der Eingang 2 der Schaltungsanordnung mit Phasendetektor 18 von Figur 1 ist an einen Quarz-Oszillator 19 angeschlossen. An den Ausgang 11 der Schaltungsanordnung 18 ist, über ein den Regelkreis stabilisierendes Schleifenfilter 20, der Steuereingang eines spannungsgesteuerten Oszillators 21 angeschlossen. Der Ausgang des Oszillators 21 bildet einerseits den Ausgang der gesamten Phasenregelschleife und ist außerdem über einen Fractional-n-Frequenzteiler 22 an den weiteren Eingang 3 der Schaltungsanordnung 18 mit Phasendetektor und Ladungspumpen-Ausgangsstufe angeschlossen. Der Fractional-n-Frequenzteiler 22 wird von einem Modulationssignal MOD und einem Signal zur Kanalvorwahl CH über einen Sigma-Delta-∑Δ-Wandler 23 angesteuert.

In dem beschriebenen Fractional-n-Phasenregelkreis kommt das Prinzip der vorliegenden Erfindung, nämlich mit geringem Aufwand im Arbeitspunkt des Phasendetektors einen hochlinearen Zusammenhang zwischen dessen Ausgangsstrom und der Phasendifferenz der beiden Eingangssignale zu erreichen, und dabei eine geringe Chipfläche einzunehmen, besonders vorteilhaft zur Geltung.

### Bezugszeichenliste

- 1: Phasendetektor
- 2: Eingang
- 3: Eingang
- 4: Ausgang
- 5: Ausgang
- 6: Schalter
- 7: Schalter
- 8: Ausgangsstufe/Ladungspumpe
- 9: Stromquelle
- 10: Versorgungspotentialanschluß
- 11: Signalausgang
- 12: Bezugspotentialanschluß
- 13: Stromquelle
- 14: Referenzstromeingang
- 15: Referenzstromquelle
- 16: Referenzstromquelle
- 17: Referenzstromquelle
- 18: Phasendetektor mit Ladungspumpenausgang
- 19: Quarz-Oszillator
- 20: Schleifenfilter
- 21: Spannungsgesteuerter Oszillator
- 22: Fractional-n-Frequenzteiler
- 23: ∑Δ-Wandler

## Patentansprüche

1. Schaltungsanordnung mit Phasendetektor, aufweisend
- den Phasendetektor (1) mit einem ersten Eingang (3) zum Zuführen eines Eingangssignal mit einer ersten Phasenlage (Φ1) und mit einem zweiten Eingang (2) zum Zuführen eines Eingangssignals mit einer zweiten Phasenlage (Φ2),
- eine Ausgangsstufe (8) mit einer ersten Stromquelle (9) und mit einer zweiten Stromquelle (13),
- einen zweiten Schalter (7), der zum Zu-/ und Abschalten der zweiten Stromquelle (13) mit dieser gekoppelt ist, mit einem Steuereingang, der mit einem zweiten Ausgang (5) des Phasendetektors (1) verbunden ist, wobei an dem zweiten Ausgang (5) ein Abwärts-Steuersignal , und
- einen Signalausgang (11) der Schaltungsanordnung, der mit der ersten und der zweiten Stromquelle (9, 13) gekoppelt ist und der ausgelegt ist zur Bereitstellung eines Ausgangsstroms in Abhängigkeit von einer Phasenabweichung zwischen der ersten und der zweiten Phasenlage (Φ1, Φ2) der Eingangssignale des Phasendetektors (1) derart, dass die Kennlinie des Phasendetektors (1), die den Ausgangsstrom aufgetragen über den Phasenunterschied der Eingangssignale repräsentiert, außerhalb des Ursprungs verläuft,
**dadurch gekennzeichnet, daß** die Schaltungsanordnung
- einen ersten Schalter (6) zum Ansteuern der ersten Stromquelle (9) aufweist, der einen Referenzstromeingang der Stromquelle (9) entweder mit einer ersten Referenzstromquelle (15) oder mit einer zweiten Referenzstromquelle (16) koppelt und der einen Steuereingang aufweist, der an einen ersten Ausgang (4) des Phasendetektors (1) angeschlossen ist, wobei an dem ersten Ausgang (4) ein Aufwärts-Steuersignal in Abhängigkeit von einem Phasenunterschied zwischen den Eingangssignalen an den Eingängen (2, 3) des Phasendetektors (1) bereitgestellt wird.

2. Schaltungsanordnung nach Anspruch 1,
**dadurch gekennzeichnet, daß**
die erste und die zweite Stromquelle (9, 13) zur Bildung einer Serienschaltung zwischen einen Versorgungspotentialanschluß (10) und einen Bezugspotentialanschluß (12) in der Ausgangsstufe (8) der Schaltungsanordnung angeordnet sind.

3. Schaltungsanordnung nach Anspruch 1 oder 2
**dadurch gekennzeichnet, daß**
der zweite Schalter (7) die zweite Stromquelle (13) und den Signalausgang (11) der Schaltungsanordnung zu-/ und abschaltbar miteinander koppelt.

4. Schaltungsanordnung nach Anspruch 1 oder 2,
**dadurch gekennzeichnet, daß**
der zweite Schalter (7) einen Referenzstromeingang der zweiten Stromquelle mit einer dritten Referenzstromquelle (17) zu-/ und abschaltbar koppelt.

5. Phasenregelschleife mit einer Schaltungsanordnung gemäß einem der Patentansprüche 1 bis 4, aufweisend
- einen gesteuerten Oszillator (21) mit einem Steuereingang, der über ein Schleifenfilter (20) an den Signalausgang der Schaltungsanordnung (18) mit Phasendetektor angeschlossen ist, und mit einem Ausgang,
- einen Frequenzteiler (22), der den Ausgang des gesteuerten Oszillators (21) mit dem ersten Eingang (3) des Phasendetektors (1) koppelt, und
- einen Bezugsfrequenz-Generator (19), der mit dem zweiten Eingang (2) des Phasendetektors gekoppelt ist.

6. Phasenregelschleife nach Anspruch 5,
**dadurch gekennzeichnet, daß**
der Frequenzteiler (22) als Fractional-N-Teiler ausgelegt ist, mit einem Steuereingang zum Zuführen eines aufbereiteten Modulationssignals.

## Claims

1. Circuit arrangement having a phase detector, having
- the phase detector (1), which has a first input (3) for supplying an input signal having a first phase angle (Φ1) and a second input (2) for supplying an input signal having a second phase angle (Φ2),
- an output stage (8), which has a first current source (9) and a second current source (13),
- a second switch (7), which is coupled to the second current source (13) for the purpose of connecting and disconnecting the latter and has a control input, which is connected to a second output (5) of the phase detector (1), a downlink control signal being provided at the second output (5) in a manner dependent on a phase difference between the input signals at the inputs (2, 3) of the phase detector (1), and
- a signal output (11) of the circuit arrangement, said signal output being coupled to the first and the second current source (9, 13) and being designed for the purpose of providing an output current in a manner dependent on a phase deviation between the first and the second phase angle (Φ1, Φ2) of the input signals of the phase detector (1) in such a manner that the characteristic curve of the phase detector (1), which represents the output current plotted against the phase difference between the input signals, runs outside the origin,
**characterized in that** the circuit arrangement has
- a first switch (6) for driving the first current source (9), said switch coupling a reference current input of the current source (9) either to a first reference current source (15) or to a second reference current source (16) and having a control input, which is connected to a first output (4) of the phase detector (1), an uplink control signal being provided at the first output (4) in a manner dependent on a phase difference between the input signals at the inputs (2, 3) of the phase detector (1).

2. Circuit arrangement according to Claim 1,
**characterized in that**
the first and second current sources (9, 13) are arranged in the output stage (8) of the circuit arrangement in order to form a series circuit between a supply potential terminal (10) and a reference potential terminal (12).

3. Circuit arrangement according to Claim 1 or 2,
**characterized in that**
the second switch (7) couples the second current source (13) and the signal output (11) of the circuit arrangement to one another in such a manner that they can be connected and disconnected.

4. Circuit arrangement according to Claim 1 or 2,
**characterized in that**
the second switch (7) couples a reference current input of the second current source to a third reference current source (17) in such a manner that it can be connected and disconnected.

5. Phase locked loop having a circuit arrangement according to one of Patent Claims 1 to 4, having
- a controlled oscillator (21), which has a control input, which is connected to the signal output of the circuit arrangement (18) having a phase detector via a loop filter (20), and an output,
- a frequency divider (22), which couples the output of the controlled oscillator (21) to the first input (3) of the phase detector (1), and
- a reference frequency generator (19), which is coupled to the second input (2) of the phase detector.

6. Phase locked loop according to Claim 5,
**characterized in that**
the frequency divider (22) is in the form of a fractional-N-divider and has a control input for supplying a conditioned modulation signal.

## Revendications

1. Circuit ayant un détecteur de phase et comprenant
- le détecteur (1) de phase ayant une première entrée (3) d'entrée d'un signal d'entrée ayant une première position (φ1) de phase et une deuxième entrée (2) d'entrée d'un signal d'entrée ayant une deuxième position (φ2) de phase,
- un étage (8) de sortie ayant une première source (9) de courant et ayant une deuxième source (13) de courant,
- un deuxième commutateur (7) qui, pour la mise en circuit et hors circuit de la deuxième source (13) de courant, est couplé à celle-ci et qui a une entrée de commande qui est reliée à une deuxième sortie (5) du détecteur (1) de phase, dans lequel il est mis à disposition sur la deuxième sortie (5) un signal de commande vers le bas en fonction d'une différence de phase entre les signaux d'entrée sur les entrées (2, 3) du détecteur (1) de phase, et
- une sortie (11) de signal du circuit, qui est couplée à la première et la deuxième source (9, 13) de courant et qui est conçue pour disposer d'un courant de sortie en fonction d'un écart de phase entre la première et la deuxième position (φ1, φ2) de phase des signaux d'entrée du détecteur (1) de phase, de sorte que la courbe caractéristique du détecteur (1) de phase, qui représente le courant de sortie porté en fonction de la différence de phase des signaux d'entrée, passe en dehors de l'origine,
**caractérisé en ce que** le circuit comprend
- un premier commutateur (6) pour commander la première source (9) de courant qui couple une entrée de courant de référence de la source (9) de courant soit à une première source (15) de courant de référence, soit à une deuxième source (16) de courant de référence, et qui a une entrée de commande qui est raccordée à une première sortie (4) du détecteur (1) de phase, dans lequel il est mis à disposition, sur la première sortie (4), un signal de commande vers le haut en fonction d'une différence de phase entre les signaux d'entrée sur les entrées (2, 3) du détecteur (1) de phase.

2. Circuit suivant la revendication 1,
**caractérisé en ce que** la première et la deuxième source (9, 13) de courant sont, pour former un circuit série, disposées entre une borne (10) de potentiel d'alimentation et une borne (12) de potentiel de référence dans l'étage (8) de sortie du circuit.

3. Circuit suivant la revendication 1 ou 2,
**caractérisé en ce que** le deuxième commutateur (7) couple entre eux, pour la mise en circuit et hors circuit, la deuxième source (13) de courant et la sortie (11) du signal du montage.

4. Circuit suivant la revendication 1 ou 2,
**caractérisé en ce que** le deuxième commutateur (7) couple, pour la mise en circuit et hors circuit, une entrée du courant de référence de la deuxième source de courant à une troisième source (17) de courant de référence.

5. Boucle d'asservissement de phase comprenant un circuit suivant l'une des revendications 1 à 4 et comportant
- un oscillateur (21) commandé ayant une entrée de commande, qui est raccordé par un filtre (20) à boucle à la sortie du signal du circuit (18) ayant un détecteur de phase, et une sortie,
- un diviseur (22) de fréquence qui couple la sortie de l'oscillateur (21) commandé à la première entrée (3) du détecteur (1) de phase, et
- un générateur (19) de fréquence de référence qui est couplé à la deuxième entrée (2) du détecteur de phase.

6. Boucle d'asservissement de phase suivant la revendication 5,
**caractérisée en ce que** le diviseur (22) de fréquence est conçu sous la forme d'un N diviseur fractionnel ayant une entrée de commande pour l'entrée d'un signal de modulation préparé.
